# EUROPÄISCHE PATENTSCHRIFT

(11) **EP 3 226 269 B1**
(45) Veröffentlichungstag und Bekanntmachung des Hinweises auf die Patenterteilung: **20.06.2018**
(21) Anmeldenummer: 17157758.8
(22) Anmeldetag: 24.02.2017
(51) Int. Cl.: H05K 3/00, H01G 4/40, H01G 4/38, H01G 2/06, H01G 2/08, H01L 23/049, H01L 23/48, H05K 3/32, H05K 3/30, H05K 1/02

(54) **LEISTUNGSHALBLEITEREINRICHTUNG**
POWER SEMICONDUCTOR DEVICE
DISPOSITIF SEMI-CONDUCTEUR DE PUISSANCE

(30) Priorität: 30.03.2016 DE 102016105783
(43) Veröffentlichungstag der Anmeldung: 04.10.2017
(73) Patentinhaber: SEMIKRON Elektronik GmbH & Co. KG, 90431 Nürnberg (DE)
(72) Erfinder: Frank, Thomas, 91207 Lauf (DE); Walter, Christian, 91522 Ansbach (DE); Weiß, Stefan, 91315 Höchstadt (DE); Ziegler, Thomas, 91287 Plech (DE)

(56) Entgegenhaltungen:
- DE-B3-102014 116 058
- DE-U1-202016 101 292

## Beschreibung

Die Erfindung betrifft eine Leistungshalbleitereinrichtung.

Bei aus dem Stand der Technik bekannten Leistungshalbleitereinrichtungen sind im Allgemeinen auf einem Substrat Leistungshalbleiterbauelemente, wie z.B. Leistungshalbleiterschalter und Dioden angeordnet und mittels einer Leiterschicht des Substrats, Bonddrähten und/oder einem elektrisch leitenden Folienverbund miteinander elektrisch leitend verbunden.

Die Leistungshalbleiterbauelemente sind dabei häufig elektrisch zu einer einzelnen oder mehreren sogenannten Halbbrückenschaltungen verschalten, die z.B. zum Gleich- und Wechselrichten von elektrischen Spannungen und Strömen verwendet werden. Leistungshalbleitereinrichtungen weisen dabei im Allgemeinen als Energiespeicher elektrisch parallel und/oder in Reihe geschaltete Kondensatoren auf, die im Allgemeinen eine an der Leistungshalbleitereinrichtung auftretende Gleichspannung puffern. Solche Kondensatoren werden fachüblich auch als Zwischenkreiskondensatoren bezeichnet.

Die Kondensatoren sind über ihre elektrischen Anschlusselemente mit einem einzelnen oder mehreren Komponenten der Leistungshalbleitereinrichtung, insbesondere mit den Leistungshalbleiterbauelementen der Leistungshalbleitereinrichtung elektrisch leitend verbunden. Da Leistungshalbleitereinrichtungen häufig mechanischen Stoß- und/oder Schwingungsbelastungen ausgesetzt sind, kann es zu einem mechanischen Versagen und damit zu einer elektrischen Unterbrechung der elektrischen Verbindung zwischen den elektrischen Anschlusselementen der Kondensatoren und dem Substrat der Leistungshalbleitereinrichtung, auf dem die Leistungshalbleiterbauelemente der Leistungshalbleitereinrichtung angeordnet sind, kommen, was zu einer Fehlfunktion der Leistungshalbleitereinrichtungen führt.

Aus der DE 10 2009 046 403 A1 ist eine Leistungshalbleitereinrichtung bekannt, bei der die elektrischen Anschlusselemente der Kondensatoren über in Normelenrichtung des Substrats der Leistungshalbleitereinrichtung starre unnachgiebige Kontaktfüße, die mit den elektrischen Anschlusselementen der Kondensatoren stoffschlüssig verbunden sind, mit dem Substrat der Leistungshalbleitereinrichtung elektrisch leitend verbunden sind. DE102014116058B3 betrifft eine Leistungshalbleitereinrichtung mit Leistungshalbleiterbauelementen, mit einem Grundkörper und mit hintereinander angeordneten Kondensatoren, wobei die Leistungshalbleitereinrichtung eine Kondensatorbefestigungsvorrichtung aufweist, die einen ersten und einen zweiten Befestigungskörper aufweist. Es ist Aufgabe der Erfindung eine Leistungshalbleitereinrichtung zu schaffen, deren Kondensatoren zuverlässig elektrisch leitend mit dem Substrat der Leistungshalbleitereinrichtung verbunden sind.

Diese Aufgabe wird gelöst durch eine Leistungshalbleitereinrichtung mit einem eine erste und eine zweite elektrisch leitende Kontaktfläche aufweisenden Substrat auf dem Leistungshalbleiterbauelemente angeordnet und mit dem Substrat elektrisch leitend verbunden sind, und mit einem elektrischen Kondensator, der zum elektrischen Anschluss des Kondensators ein elektrisch leitendes erstes und ein elektrisch leitendes zweites Kondensatoranschlusselement aufweist, und mit einem ersten und einem zweiten Druckelement, wobei ein erster Abschnitt des ersten Kondensatoranschlusselements zwischen dem ersten Druckelement und der ersten Kontaktfläche des Substrats angeordnet ist und ein erster Abschnitt des zweiten Kondensatoranschlusselements zwischen dem zweiten Druckelement und der zweiten Kontaktfläche des Substrats angeordnet ist, wobei die Leistungshalbleitereinrichtung derart ausgebildet ist, dass das erste Druckelement den ersten Abschnitt des ersten Kondensatoranschlusselements gegen die erste Kontaktfläche des Substrats drückt, so dass das erste Kondensatoranschlusselement mit der ersten Kontaktfläche des Substrats elektrisch leitend druckkontaktiert ist, und dass das zweite Druckelement den ersten Abschnitt des zweiten Kondensatoranschlusselements gegen die zweite Kontaktfläche des Substrats drückt, so dass das zweite Kondensatoranschlusselement mit der zweiten Kontaktfläche des Substrats elektrisch leitend druckkontaktiert ist.

Weiterhin wir diese Aufgabe gelöst durch eine Leistungshalbleitereinrichtung mit einem eine erste und eine zweite elektrisch leitende Kontaktfläche aufweisenden Substrat auf dem Leistungshalbleiterbauelemente angeordnet und mit dem Substrat elektrisch leitend verbunden sind, und mit einem elektrischen Kondensator, der zum elektrischen Anschluss des Kondensators ein elektrisch leitendes erstes und ein elektrisch leitendes zweites Kondensatoranschlusselement aufweist, und mit einem ersten und einem zweiten Federelement, und mit einem eine Aufnahmeeinrichtung zur Aufnahme des Kondensators aufweisenden Kondensatorhalteelement, wobei der Kondensator in der Aufnahmeeinrichtung des Kondensatorhaltelements angeordnet ist, wobei das erste Federelement einen elektrisch leitenden Kontakt mit dem ersten Kondensatoranschlusselement aufweist und das zweite Federelement einen elektrisch leitenden Kontakt mit dem zweiten Kondensatoranschlusselement aufweist, wobei die Leistungshalbleitereinrichtung derart ausgebildet ist, dass das Kondensatorhaltelement das erste Federelement gegen die erste Kontaktfläche des Substrats drückt, so dass das erste Federelement mit der ersten Kontaktfläche des Substrats elektrisch leitend druckkontaktiert ist und dass das Kondensatorhaltelement das zweite Federelement gegen die zweite Kontaktfläche des Substrats drückt, so dass das zweite Federelement mit der zweiten Kontaktfläche des Substrats elektrisch leitend druckkontaktiert ist.

Vorteilhafte Ausbildungen der Erfindung ergeben sich aus den abhängigen Ansprüchen.

Es erweist sich als vorteilhaft, wenn die Leistungshalbleitereinrichtung ein, eine Aufnahmeeinrichtung zur Aufnahme des Kondensators aufweisendes Kondensatorhalteelement aufweist, wobei der Kondensator in der Aufnahmeeinrichtung des Kondensatorhaltelements angeordnet ist, wobei das erste und zweite Druckelement mit dem Kondensatorhaltelement einstückig ausgebildet sind oder ein jeweiliger Abschnitt des ersten und zweiten Druckelements in das Kondensatorhalteelement eingespritzt ist oder ein jeweiliger Abschnitt des ersten und zweiten Druckelements in einer jeweilig zugeordneten Ausnehmung des Kondensatorhalteelements angeordnet ist. Hierdurch wird eine besonderes einfache Befestigungsmöglichkeit des ersten und zweiten Druckelements am Kondensatorhaltelement geschaffen.

Es erweist sich als vorteilhaft, wenn das erste und zweite Druckelement in Normalenrichtung des Substrats federnd ausgebildet sind. Hierdurch können Monate- und Bauteiltoleranzen ausgeglichen werden können und eine konstante definierte Andruckkraft des ersten und zweiten Druckelements auf den jeweiligen ersten Abschnitt des jeweiligen Kondensatoranschlusselements erzielt werden.

Weiterhin erweist es sich als vorteilhaft, wenn die Aufnahmeeinrichtung ein Aufnahmehalteelement aufweist, wobei der Kondensator in Normalenrichtung des Substrats zwischen dem Aufnahmehalteelement und dem Substrat angeordnet ist, da dann der Kondensator zuverlässig vom Kondensatorhaltelement gehalten wird.

Ferner erweist es sich als vorteilhaft, wenn die Leistungshalbleitereinrichtung eine Grundplatte und ein Druckerzeugungsmittel aufweist, wobei das Substrat zwischen der Aufnahmeeinrichtung des Kondensatorhaltelements und der Grundplatte angeordnet ist und das Kondensatorhaltelement mittels des Druckerzeugungsmittels an der Grundplatte befestigt ist, wobei das Druckerzeugungsmittel Druck auf das Kondensatorhaltelement in Richtung auf das Substrat zu ausübt und hierdurch das erste Druckelement den ersten Abschnitt des ersten Kondensatoranschlusselements gegen die erste Kontaktfläche des Substrats drückt, so dass das erste Kondensatoranschlusselement mit der ersten Kontaktfläche des Substrats elektrisch leitend druckkontaktiert ist, und das zweite Druckelement den ersten Abschnitt des zweiten Kondensatoranschlusselements gegen die zweite Kontaktfläche des Substrats drückt, so dass das zweite Kondensatoranschlusselement mit der zweiten Kontaktfläche des Substrats elektrisch leitend druckkontaktiert ist. Hierdurch wird auf einfache Art und Weise Druck auf das Kondensatorhaltelement in Richtung auf das Substrat zu ausgeübt.

Weiterhin erweist es sich als vorteilhaft, wenn die Leistungshalbleitereinrichtung ein, eine Aufnahmeeinrichtung zur Aufnahme des Kondensators aufweisendes Kondensatorhalteelement aufweist, wobei der Kondensator in der Aufnahmeeinrichtung des Kondensatorhaltelements in Normalenrichtung des Substrats beweglich angeordnet ist, wobei das erste Druckelement mit dem zweiten Druckelement einstückig ausgebildet ist, wobei das erste und zweite Druckelement integraler Bestandteil eines zwischen dem Kondensatorhaltelement und dem Substrat angeordneten Andruckelements sind, wobei die Leistungshalbleitereinrichtung ein erstes Federelement aufweist, wobei der Kondensator in Normalenrichtung des Substrats zwischen dem ersten Federelement und dem Andruckelement angeordnet ist, wobei das erste Federelement den Kondensator in Normalenrichtung des Substrats gegen das Andruckelement drückt und hierdurch das erste Druckelement den ersten Abschnitt des ersten Kondensatoranschlusselements gegen die erste Kontaktfläche des Substrats drückt, so dass das erste Kondensatoranschlusselement mit der ersten Kontaktfläche des Substrats elektrisch leitend druckkontaktiert ist, und das zweite Druckelement den ersten Abschnitt des zweiten Kondensatoranschlusselements gegen die zweite Kontaktfläche des Substrats drückt, so dass das zweite Kondensatoranschlusselement mit der zweiten Kontaktfläche des Substrats elektrisch leitend druckkontaktiert ist. Hierdurch wird auf einfache Art und Weise der Kondensator in Normalenrichtung des Substrats gegen das Andruckelement gedrückt.

In diesem Zusammenhang erweist es sich als vorteilhaft, wenn die Leistungshalbleitereinrichtung eine Grundplatte und ein Druckerzeugungsmittel aufweist, wobei das Substrat zwischen der Aufnahmeeinrichtung des Kondensatorhaltelements und der Grundplatte angeordnet ist, wobei das erste Federelement mit dem Kondensatorhaltelement einstückig ausgebildet ist, wobei das Kondensatorhaltelement mittels des Druckerzeugungsmittels an der Grundplatte befestigt ist, wobei das Druckerzeugungsmittel Druck auf das Kondensatorhaltelement in Richtung auf das Substrat zu und damit Druck auf das erste Federelement in Richtung auf den Kondensator zu ausübt. Hierdurch wird auf einfache Art und Weise Druck auf das Kondensatorhaltelement in Richtung auf das Substrat zu ausgeübt.

In diesem Zusammenhang erweist es sich alternativ als vorteilhaft, wenn die Leistungshalbleitereinrichtung eine Grundplatte und ein Druckerzeugungsmittel aufweist, wobei das Substrat zwischen der Aufnahmeeinrichtung des Kondensatorhaltelements und der Grundplatte angeordnet ist, wobei zumindest ein Abschnitt des ersten Federelements in Form eines durch in eine Deckplatte eingebrachte Schlitze gebildeten Bereichs der Deckplatte ausgebildet ist, wobei die Deckplatte mit dem Kondensatorhaltelement verbundenen ist, wobei das Kondensatorhaltelement mittels des Druckerzeugungsmittels an der Grundplatte befestigt ist, wobei das Druckerzeugungsmittel Druck auf das Kondensatorhaltelement in Richtung auf das Substrat zu und damit Druck auf das erste Federelement in Richtung auf den Kondensator zu ausübt. Hierdurch wird auf einfache Art und Weise Druck auf das Kondensatorhaltelement in Richtung auf das Substrat zu ausgeübt. Weiterhin erweist es sich als vorteilhaft, wenn dass das Kondensatorhaltelement an seiner dem Substrat zugewandten Seite in Richtung des Substrats hervorstehende zweite Federelemente aufweist, wobei die zweiten Federelemente das Substrat gegen die Grundplatte drücken. Hierdurch wird das Substrat zusätzlich auch von dem Kondensatorhaltelement über deren zweiten Federelemente gegen die Grundplatte gedrückt.

Ferner erweist es sich im Rahmen der weiteren Lösung der Aufgabe als vorteilhaft, wenn Kondensatorhalteelement eine dem jeweiligen Federelement zugeordnete Aufnahmeeinrichtung zur Aufnahme des jeweiligen Federelements aufweist, wobei ein jeweiliger Abschnitt des ersten und zweiten Federelements in der dem jeweiligen Federelement zugeordneten Aufnahmeeinrichtung angeordnet ist. Hierdurch wird das jeweilige Federelement auf einfache Art und Weise an dem Kondensatorhalteelement befestigt.

Im Zusammenhang mit der weiten Lösung der Aufgabe erweist es sich als vorteilhaft, wenn das erste Federelement mindestens eine Öffnung aufweist durch die ein Abschnitt des ersten Kondensatoranschlusselements hindurchverläuft und dass das zweite Federelement mindestens eine Öffnung aufweist durch die ein Abschnitt des zweiten Kondensatoranschlusselements hindurchverläuft. Hierdurch wird das jeweilige Federelement auf besonders einfache Art und Weise an dem Kondensatorhalteelement befestigt.

Im Zusammenhang mit der weiten Lösung der Aufgabe erweist es sich als vorteilhaft, wenn der elektrisch leitende Kontakt des ersten Federelements mit dem ersten Kondensatoranschlusselement und der elektrisch leitende Kontakt des zweiten Federelements mit dem zweiten Kondensatoranschlusselement jeweilig als elektrisch leitender Druckkontakt oder als elektrisch leitender stoffschlüssiger Kontakt ausgebildet ist, da dann die Verbindung zwischen den Federelementen und den Kondensatoranschlusselementen besonders zuverlässig ausgebildet ist.

Ferner erweist es sich im Rahmen der weiteren Lösung der Aufgabe als vorteilhaft, wenn die Leistungshalbleitereinrichtung eine Grundplatte und ein Druckerzeugungsmittel aufweist, wobei das Substrat zwischen der Aufnahmeeinrichtung des Kondensatorhaltelements und der Grundplatte angeordnet ist und das Kondensatorhaltelement mittels des Druckerzeugungsmittels an der Grundplatte befestigt ist, wobei das Druckerzeugungsmittel Druck auf das Kondensatorhaltelement in Richtung auf das Substrat zu ausübt und hierdurch das Kondensatorhaltelement das erste Federelement gegen die erste Kontaktfläche des Substrats drückt und das zweite Federelement gegen die zweite Kontaktfläche des Substrats drückt. Hierdurch wird auf einfache Art und Weise Druck auf das Kondensatorhaltelement in Richtung auf das Substrat zu ausgeübt.

Weiterhin erweist es sich als vorteilhaft, wenn das Substrat gegen die Grundplatte drückt und hierdurch das Substrat mit der Grundplatte kraftschlüssig verbunden ist, da dann das Substrat zuverlässig mit der Grundplatte verbunden ist.

Ferner erweist es sich als vorteilhaft, wenn das Druckerzeugungsmittel als mindestens eine Schraubverbindung ausgebildet ist, da dann das Druckerzeugungsmittel besonders einfach ausgebildet ist.

Weiterhin erweist es sich als vorteilhaft, wenn das Substrat als Direct Copper Bonded Substrat oder als Insulated Metal Substrat ausgebildet ist, da diese technikübliche Substrate auf denen Leistungshalbleiterbauelemente angeordnet werden, darstellen.

Ausführungsbeispiele der Erfindung werden nachfolgend unter Bezugnahme auf die unten stehenden Figuren erläutert. Dabei zeigen:
- FIG 1: eine perspektivische Darstellung einer ersten Ausbildung einer erfindungsgemäßen Leistungshalbleitereinrichtung,
- FIG 2: eine Seitenansicht einer ersten Ausbildung einer erfindungsgemäßen Leistungshalbleitereinrichtung,
- FIG 3: eine Detailansicht von FIG 2,
- FIG 4: eine Detailansicht von FIG 2 einer Ausbildungsvariante einer ersten Ausbildung einer erfindungsgemäßen Leistungshalbleitereinrichtung,
- FIG 5: eine perspektivische Darstellung einer zweiten Ausbildung einer erfindungsgemäßen Leistungshalbleitereinrichtung,
- FIG 6: eine perspektivische Darstellung eines Kondensatorhalteelements einer zweiten Ausbildung einer erfindungsgemäßen Leistungshalbleitereinrichtung,
- FIG 7: eine perspektivische Darstellung eines Abdruckelements und eines an dem Andruckelement angeordneten Kondensators einer zweiten Ausbildung einer erfindungsgemäßen Leistungshalbleitereinrichtung,
- FIG 8: eine Seitenansicht eines Abdruckelements und eines an dem Andruckelement angeordneten Kondensators einer zweiten Ausbildung einer erfindungsgemäßen Leistungshalbleitereinrichtung,
- FIG 9: eine perspektivische Darstellung eines Kondensatorhalteelements, wobei in Aufnahmeeinrichtungen des Kondensatorhalteelements Kondensatoren angeordnet sind und an den Kondensatoren Andruckelemente angeordnet sind, einer zweiten Ausbildung einer erfindungsgemäßen Leistungshalbleitereinrichtung,
- FIG 10: eine perspektivische Darstellung eines Kondensators mit Kondensatoranschlusselementen, die auf Kontaktflächen eines Substrats aufliegen, einer ersten und zweiten Ausbildung einer erfindungsgemäßen Leistungshalbleitereinrichtung (Kondensatorhalteelement und Druckelemente sind nicht dargestellt),
- FIG 11: eine Seitenansicht einer Ausbildungsvariante einer zweiten Ausbildung einer erfindungsgemäßen Leistungshalbleitereinrichtung mit einer Deckplatte,
- FIG 12: eine Ansicht von oben auf die in FIG 11 dargestellte Deckplatte,
- FIG 13: eine Explosionsdarstellung einer Anordnung, bestehend aus einem Kondensator, einem Kondensatorhalteelement und Federelementen, einer dritten Ausbildung einer erfindungsgemäßen Leistungshalbleitereinrichtung,
- FIG 14: eine perspektivische Darstellung einer Anordnung, bestehend aus einem Kondensator, einem Kondensatorhalteelement und Federelementen, einer dritten Ausbildung einer erfindungsgemäßen Leistungshalbleitereinrichtung und
- FIG 15: eine Seitenansicht einer Anordnung, bestehend aus einem Kondensator, einem Kondensatorhalteelement, Federelementen, einem Substrat und Leistungshalbleiterbauelementen einer dritten Ausbildung einer erfindungsgemäßen Leistungshalbleitereinrichtung.

In den Figuren sind gleiche Elemente mit gleichen Bezugszeichen versehen.

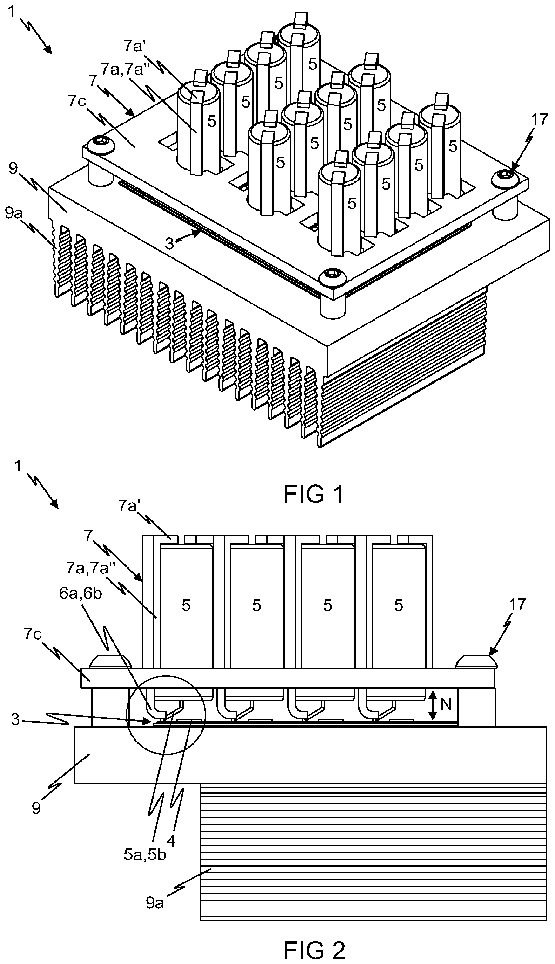

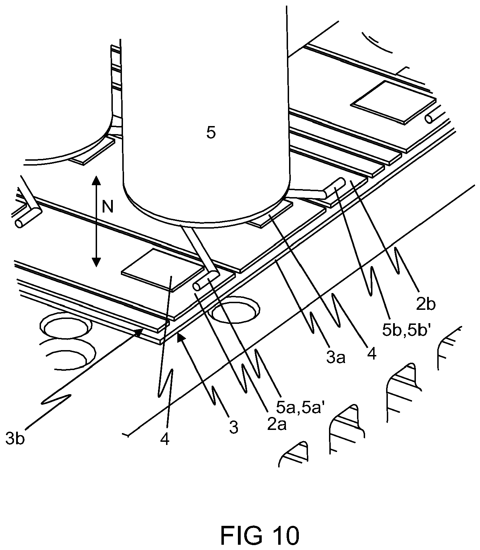

In den Figuren 1 bis 4 und 10 sind verschiedene Ansichten einer ersten Ausbildung einer erfindungsgemäßen Leistungshalbleitereinrichtung 1 dargestellt.

Die erfindungsgemäße Leistungshalbleitereinrichtung 1 weist ein, eine erste und eine zweite elektrisch leitende Kontaktfläche 2a und 2b aufweisendes Substrat 3 auf, auf dem Leistungshalbleiterbauelemente 4 angeordnet und mit dem Substrat 3 elektrisch leitend verbunden sind. Das Substrat 3 weist eine elektrisch isolierende Schicht 3a, die z.B. in Form einer Keramikplatte oder einer elektrisch isolierenden Folie ausgebildet sein kann, auf. Auf der elektrisch isolierenden Schicht 3a ist eine strukturierte elektrisch leitende erste Schicht 3b angeordnet, die infolge ihrer Struktur, die erste und zweite elektrisch leitende Kontaktfläche 2a und 2b, sowie gegebenenfalls noch weitere elektrisch leitende Kontaktflächen ausbildet. Die elektrisch leitenden Kontaktflächen können Leiterbahnen ausbilden. Die Leistungshalbleiterbauelemente 4 sind auf der ersten Schicht 3b angeordnet und mit der ersten Schicht 3b, vorzugsweise mittels einer Löt- oder Sinterverbindung, elektrisch leitend verbunden. Das Substrat 3 weist vorzugsweise eine vorzugsweise unstrukturierte elektrisch leitende zweite Schicht 3c auf, wobei die elektrisch isolierende Schicht 3a zwischen der ersten und zweiten Schicht 3b und 3c angeordnet ist. Das Substrat 3 kann z.B. als Direct Copper Bonded Substrats (DCB-Substrat) oder als Insulated Metal Substrat ausgebildet sein. Es sei angemerkt, dass das Substrat 3 ganz allgemein bei allen Ausführungsbeispielen der Erfindung, wie oben beschrieben, ausgebildet sein kann.

Das jeweilige Leistungshalbleiterbauelement 4 liegt ganz allgemein bei allen Ausführungsbeispielen der Erfindung vorzugsweise in Form eines Leistungshalbleiterschalters oder einer Diode vor. Der Leistungshalbleiterschalter liegt dabei im Allgemeinen in Form eines Transistors, wie z.B. einem IGBT (Insulated Gate Bipolar Transistor) oder MOSFET (Metal Oxide Semiconductor Field Effect Transistor), oder in Form eines Thyristors vor.

Die Leistungshalbleitereinrichtung 1 weist weiterhin einen elektrischen Kondensator 5 auf, der zu seinem elektrischen Anschluss ein elektrisch leitendes erstes und ein elektrisch leitendes zweites Kondensatoranschlusselement 5a und 5b aufweist. Die Kondensatoranschlusselemente 5a und 5b ragen aus dem Gehäuse des Kondensators 5 heraus.

Die Leistungshalbleitereinrichtung 1 weist weiterhin ein erstes und ein zweites Druckelement 6a und 6b auf, wobei ein erster Abschnitt 5a' des ersten Kondensatoranschlusselements 5a zwischen dem ersten Druckelement 6a und der ersten Kontaktfläche 2a des Substrats 3 angeordnet ist und ein erster Abschnitt 5b' des zweiten Kondensatoranschlusselements 5b zwischen dem zweiten Druckelement 6b und der zweiten Kontaktfläche 2b des Substrats 3 angeordnet ist. Die Leistungshalbleitereinrichtung 1 ist derart ausgebildet ist, dass das erste Druckelement 6a, vorzugsweise in Normalenrichtung N des Substrats 3, den ersten Abschnitt 5a' des ersten Kondensatoranschlusselements 5a gegen die erste Kontaktfläche 2a des Substrats 3 drückt, so dass das erste Kondensatoranschlusselement 5a mit der ersten Kontaktfläche 2a des Substrats 3 elektrisch leitend druckkontaktiert ist, und dass das zweite Druckelement 6b, vorzugsweise in Normalenrichtung N des Substrats 3, den ersten Abschnitt 5b' des zweiten Kondensatoranschlusselements 5b gegen die zweite Kontaktfläche 2b des Substrats 3 drückt, so dass das zweite Kondensatoranschlusselement 5b mit der zweiten Kontaktfläche 2b des Substrats 3 elektrisch leitend druckkontaktiert ist.

Bei der Erfindung sind somit die Kondensatoranschlusselemente 5a und 5b der Kondensatoren 5 nicht über eine stoffschlüssige Verbindung mit dem Substrat 3 elektrisch leitend verbunden, sondern direkt kraftschlüssig mit dem Substrat 3 elektrisch leitend verbunden, so dass keine stoffschlüssige Verbindungen (z.B. Löt-Schweiß- oder Sinterverbindung) zur elektrischen Verbindung der Kondensatoren 5 existieren, die bei mechanischen Stoß- und/oder Schwingungsbelastungen der Leistungshalbleitereinrichtung 1 versagen können.

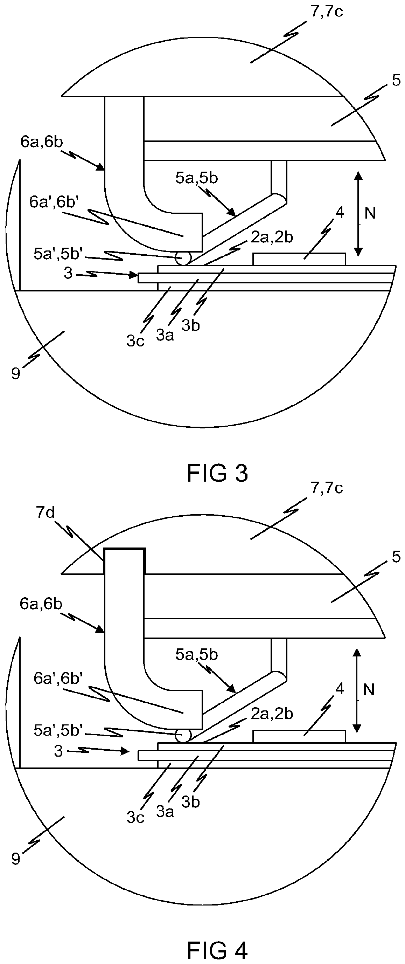

Die Leistungshalbleitereinrichtung 1 weist ein, eine Aufnahmeeinrichtung 7a zur Aufnahme des Kondensators 5 aufweisendes Kondensatorhalteelement 7 auf, wobei der Kondensator 5 in der Aufnahmeeinrichtung 7a des Kondensatorhaltelements 7 angeordnet ist, wobei das erste und zweite Druckelement 6a und 6b mit dem Kondensatorhaltelement 7 einstückig ausgebildet sind (siehe FIG 3) oder ein jeweiliger Abschnitt des ersten und zweiten Druckelements 6a und 6b in das Kondensatorhalteelement 7 eingespritzt ist oder ein jeweiliger Abschnitt des ersten und zweiten Druckelements 6a und 6b in einer jeweilig zugeordneten Ausnehmung 7d des Kondensatorhalteelements 7 angeordnet ist (siehe FIG 4). Das Kondensatorhaltelement 7 ist vorzugsweise aus Kunststoff ausgebildet. Falls ein jeweiliger Abschnitt des ersten und zweiten Druckelements 6a und 6b in das Kondensatorhalteelement 7 eingespritzt ist oder ein jeweiliger Abschnitt des ersten und zweiten Druckelements 6a und 6b in einer jeweilig zugeordneten Ausnehmung 7d des Kondensatorhalteelements 7 angeordnet ist, sind die Druckelemente 6a und 6b vorzugsweise aus Metall ausgebildet.

Das erste und zweite Druckelement 6a und 6b sind vorzugsweise in Normalenrichtung N des Substrats 3 federnd ausgebildet, wodurch Monate- und Bauteiltoleranzen ausgeglichen werden können und eine konstante definierte Andruckkraft des ersten und zweiten Druckelement 6a und 6b auf den jeweiligen ersten Abschnitt 5a' und 5b' des jeweiligen Kondensatoranschlusselements 5a bzw. 5b erreicht wird. Das erste und zweite Druckelement 6a und 6b können z.B. in Normalenrichtung N des Substrats 3 federnd ausgebildet sein, indem das erste und zweite Druckelement 6a und 6b einen jeweiligen Abschnitt 6a' bzw. 6b' aufweist, der gegenüber einem in Normalenrichtung N des Substrats 3 verlaufenden Abschnitt des jeweiligen Druckelement 6a bzw. 6b gebogen ausgeführt ist (siehe FIG 3 und FIG 4).

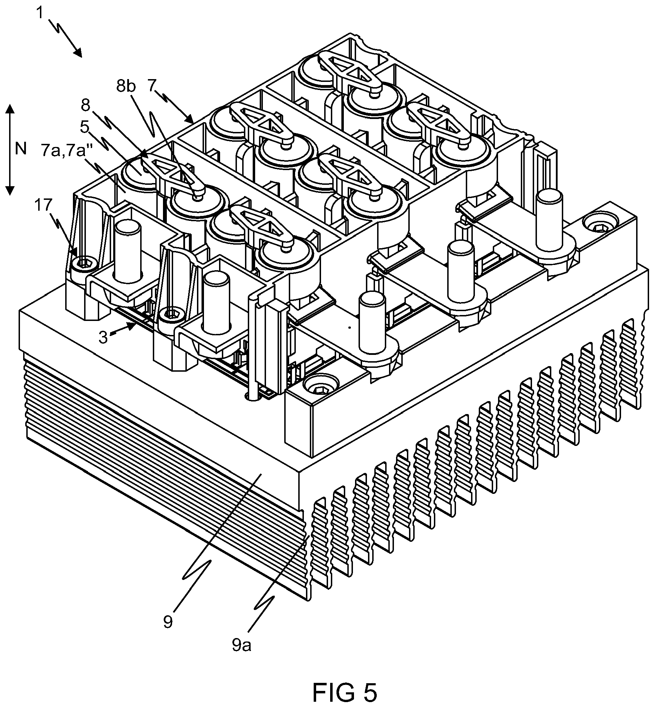

Die Aufnahmeeinrichtung 7a des Kondensatorhaltelements 7 kann Rahmenelemente 7a" aufweisen, die den Kondensator 5 zumindest teilweise lateral umschließen (siehe FIG 1) oder wie z.B. in FIG 5 dargestellt, ein hüsenförmiges Rahmenelement 7a" aufweisen, das den Kondensator 5 lateral umschließt (siehe FIG 5).

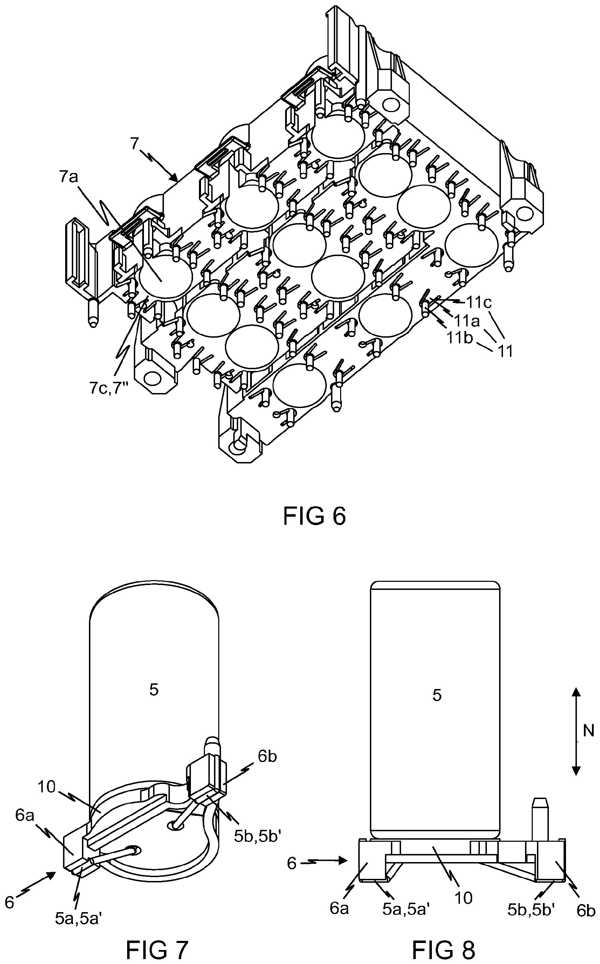

Das Kondensatorhaltelement 7 weist vorzugweise eine Kondensatorhaltelementgrundplatte 7c auf, von der sich aus die Aufnahmeeinrichtung 7a des Kondensatorhaltelements 7 in Normalenrichtung N des Substrats 3 in Richtung weg vom Substrat 3 erstreckt (siehe FIG 1 und FIG 6).

Die Aufnahmeeinrichtung 7a weist weiterhin vorzugsweise ein Aufnahmehalteelement 7a' auf, wobei der Kondensator 5 in Normalenrichtung N des Substrats 3 zwischen dem Aufnahmehalteelement 7a' und dem Substrat 5 angeordnet ist. Das Aufnahmehalteelement 7a' verhindert eine Bewegung des Kondensators 5 in Normalenrichtung N des Substrats 3 in Richtung weg vom Substrat 3. Alternativ oder zusätzlich können die Rahmenelemente 7a" oder das Rahmenelemente 7a" des Aufnahmehalteelements 7a' derart ausgebildet sein, dass sie kraftschlüssig mit dem Kondensator 5 verbunden sind.

Die Leistungshalbleitereinrichtung 1 weist vorzugsweise eine Grundplatte 9 und ein Druckerzeugungsmittel 17 auf, wobei das Substrat 3 zwischen der Aufnahmeeinrichtung 7a des Kondensatorhaltelements 7 und der Grundplatte 9 angeordnet ist und das Kondensatorhaltelement 7 mittels des Druckerzeugungsmittels 17 an der Grundplatte 9 befestigt ist, wobei das Druckerzeugungsmittel 17, vorzugsweise in Normalenrichtung N des Substrats 3, Druck auf das Kondensatorhaltelement 7 in Richtung auf das Substrat 3 zu ausübt und hierdurch das erste Druckelement 6a den ersten Abschnitt 5a' des ersten Kondensatoranschlusselements 5a gegen die erste Kontaktfläche 2a des Substrats 3 drückt, so dass das erste Kondensatoranschlusselement 5a mit der ersten Kontaktfläche 2a des Substrats 3 elektrisch leitend druckkontaktiert ist, und das zweite Druckelement 6b den ersten Abschnitt 5b' des zweiten Kondensatoranschlusselements 5b gegen die zweite Kontaktfläche 2b des Substrats 3 drückt, so dass das zweite Kondensatoranschlusselement 5b mit der zweiten Kontaktfläche 2b des Substrats 3 elektrisch leitend druckkontaktiert ist.

Die Grundplatte 9 kann z.B. mit einem Kühlkörper thermisch leitend verbunden sein oder ist, wie bei den allen Ausführungsbeispielen, integraler Bestandteil eines Kühlkörpers, der z.B. als Luftkühlkörper oder Flüssigkeitskühlkörper, insbesondere als Wasserkühlkörper, ausgebildet sein kann. Der Kühlkörper weist bei den Ausführungsbeispielen die Grundplatte 9 auf, von der Kühlfinnen 9a des Kühlkörpers ausgehen. Anstatt der Kühlfinnen 9a kann der Kühlkörper auch Kühlpins aufweisen, welche von der Grundplatte 9 ausgehen.

Das Substrat 3 drückt bei allen Ausführungsbeispielen der Erfindung vorzugsweise gegen die Grundplatte 9, insbesondere in Normalenrichtung N des Substrats 3 gegen die Grundplatte 9, wodurch hierdurch das Substrat 3 mit der Grundplatte 9 kraftschlüssig verbunden ist. Das Substrat 3 ist dabei mit der Grundplatte 9 vorzugsweise nicht stoffschlüssig verbunden. Zwischen dem Substrat 3 und Grundplatte 9 kann eine Wärmeleitpaste angeordnet sein.

Das Substrat 3 kann bei allen Ausführungsbeispielen mit der Grundplatte 9 zusätzlich auch stoffschlüssig, z.B. mittels einer Sinter- oder Lötverbindung verbunden, sein.

Das Druckerzeugungsmittel 17 ist ganz allgemein bei allen Ausführungsbeispielen der Erfindung vorzugsweise als mindestens eine Schraubverbindung ausgebildet.

In den Figuren 5 bis 12 sind verschiedene Ansichten einer zweiten Ausbildung einer erfindungsgemäßen Leistungshalbleitereinrichtung 1 dargestellt, die mit der ersten Ausbildung einer erfindungsgemäßen Leistungshalbleitereinrichtung 1 zumindest hinsichtlich der Ausbildung des Substrats 3, der Kondensatoren 5, der Grundplatte 9, der Leistungshalbleiterbauelemente 4 und der Druckerzeugungsmittel 17 übereinstimmt.

Die Leistungshalbleitereinrichtung 1 weist ein, eine Aufnahmeeinrichtung 7a zur Aufnahme des Kondensators 4 aufweisendes Kondensatorhalteelement 7 auf, wobei der Kondensator 5 in der Aufnahmeeinrichtung 7a des Kondensatorhaltelements 7 in Normalenrichtung N des Substrats 3 beweglich angeordnet ist. Die Aufnahmeeinrichtung 7a weist vorzugsweise ein hüsenförmiges Rahmenelement 7a" auf, das den Kondensator 5 lateral umschließt (siehe FIG 5), wobei die Aufnahmeeinrichtung 7a auch mehrere Rahmenelemente 7a" aufweisen kann, die den Kondensator 5 zumindest teilweise lateral umschließen (siehe FIG 1).

Das erste Druckelement 6a ist mit dem zweiten Druckelement 6b einstückig ausgebildet, wobei das erste und zweite Druckelement 6a und 6b integraler Bestandteil eines zwischen dem Kondensatorhaltelement 7 und dem Substrat 3 angeordneten Andruckelements 6 sind (siehe FIG 7 und FIG 8). Das erste Druckelement 6a ist mit dem zweiten Druckelement 6b über ein Verbindungselement 10 miteinander verbunden. Der Kondensator 5 ist auf dem Andruckelement 6, insbesondere auf dem Verbindungselement 10, angeordnet.

Die Leistungshalbleitereinrichtung 1 weist ein erstes Federelement 8 auf, wobei der Kondensator 5 in Normalenrichtung N des Substrats 3 zwischen dem ersten Federelement 8 und dem Andruckelement 6 angeordnet ist. Das erste Federelement 8 drückt den Kondensator 5 in Normalenrichtung N des Substrats 3 gegen das Andruckelement 6, wodurch hierdurch das erste Druckelement 6a den ersten Abschnitt 5a' des ersten Kondensatoranschlusselements 5a gegen die erste Kontaktfläche 2a des Substrats 3 drückt, so dass das erste Kondensatoranschlusselement 5a mit der ersten Kontaktfläche 2a des Substrats 3 elektrisch leitend druckkontaktiert ist, und wodurch hierdurch das zweite Druckelement 6b den ersten Abschnitt 5b' des zweiten Kondensatoranschlusselements 5b gegen die zweite Kontaktfläche 2b des Substrats 3 drückt, so dass das zweite Kondensatoranschlusselement 5b mit der zweiten Kontaktfläche 2b des Substrats 3 elektrisch leitend druckkontaktiert ist.

Die Leistungshalbleitereinrichtung 1 weist vorzugsweise die zuvor beschriebene Grundplatte 9 und das zuvor beschriebe Druckerzeugungsmittel 17 auf, wobei das Substrat 3 zwischen der Aufnahmeeinrichtung 7a des Kondensatorhaltelements 7 und der Grundplatte 9 angeordnet ist.

Das erste Federelement 8 kann, wie beispielhaft in FIG 5 dargestellt, mit dem Kondensatorhaltelement 7 einstückig ausgebildet sein, wobei das Kondensatorhaltelement 7 mittels des Druckerzeugungsmittels 17 an der Grundplatte 9 befestigt ist, wobei das Druckerzeugungsmittel 17, vorzugsweise in Normalenrichtung N des Substrats 3, Druck auf das Kondensatorhaltelement 7 in Richtung auf das Substrat 3 zu und damit Druck auf das erste Federelement 8 in Richtung auf den Kondensator 5 zu ausübt.

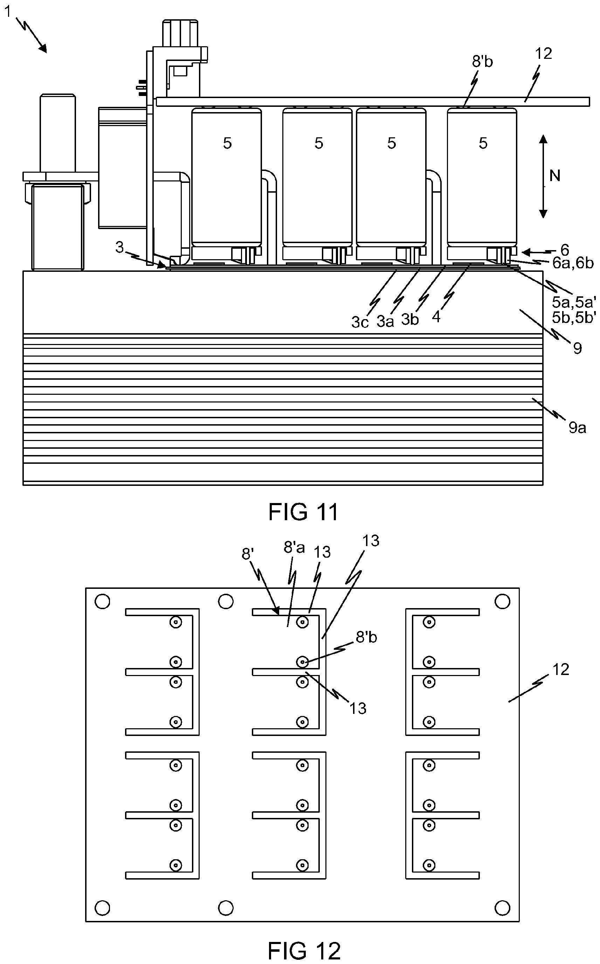

Alternativ kann, wie beispielhaft in FIG 11 und FIG 12 dargestellt, zumindest ein Abschnitt 8'a des ersten Federelements 8' in Form eines durch in eine Deckplatte 12 eingebrachte Schlitze 13 gebildeten Bereichs 8'a der Deckplatte 12 ausgebildet sein. Die Deckplatte 12 ist mit dem Kondensatorhaltelement 7 verbundenen, wobei das Kondensatorhaltelement 7 mittels des Druckerzeugungsmittels 17 an der Grundplatte 9 befestigt ist. Das Druckerzeugungsmittel 17 übt, vorzugsweise in Normalenrichtung N des Substrats 3, Druck auf das Kondensatorhaltelement 7 in Richtung auf das Substrat 3 zu aus und damit Druck auf das erste Federelement 8' in Richtung auf den Kondensator 5 zu aus. Der Kondensator 5 ist zwischen Deckplatte 12 und Andruckelement 6 angeordnet. Die Deckplatte 12 liegt vorzugsweise in Form eines metallischen Blechs, insbesondere aus einem aus Federstahl bestehenden Blechs, vor. Es sei angemerkt, dass der Übersichtlichkeit halber in FIG 11 das Kondensatorhaltelement 7 nicht dargestellt ist.

Vorzugsweise weist das erste Federelement 8 bzw. 8' mindestens eine Drucknoppe 8b bzw. 8'b auf über die das erste Federelement 8 bzw. 8' den Kondensator 5 in Normalenrichtung N des Substrats 3 gegen das Andruckelement 6 drückt.

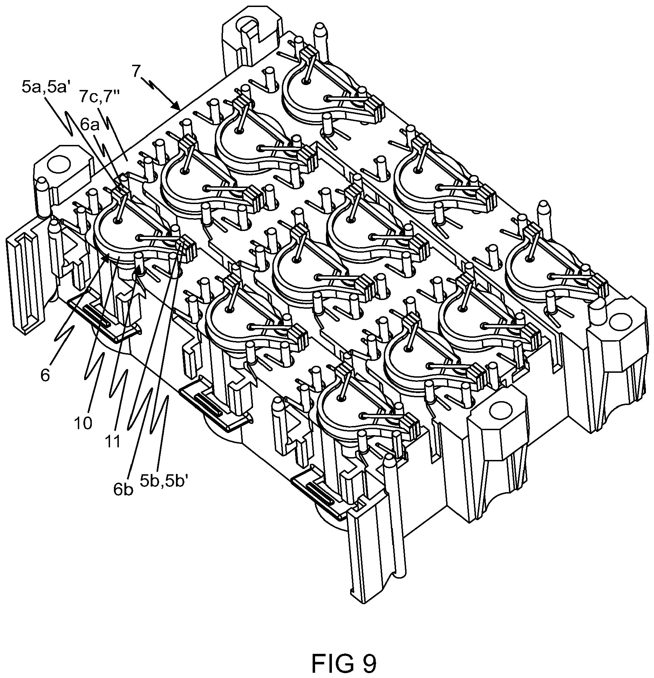

Das Kondensatorhaltelement 7 weist vorzugsweise, wie beispielhaft in FIG 6 und FIG 9 dargestellt, an seiner dem Substrat 3 zugewandten Seite 7" in Richtung des Substrats 3 hervorstehende zweite Federelemente 11 auf, die das Substrat 3, vorzugsweise in Normalenrichtung N des Substrats 3, gegen die Grundplatte 9 drücken. Hierdurch wird das Substrat 3 zusätzlich auch von dem Kondensatorhaltelement 7 über deren zweiten Federelemente 11 gegen die Grundplatte 9 gedrückt. Die zweiten Federelemente 11 sind vorzugsweise mit dem Kondensatorhaltelement 7 einstückig ausgebildet. Das Kondensatorhaltelement 7 weist vorzugweise eine Kondensatorhaltelementgrundplatte 7c auf, von der sich aus die Aufnahmeeinrichtung 7a des Kondensatorhaltelements 7 in Normalenrichtung N des Substrats 3 in Richtung weg vom Substrat 3 erstreckt (siehe FIG 6). Die zweiten Federelemente 11 stehen, vorzugsweise ausgehend Kondensatorhaltelementgrundplatte 7c, in Richtung des Substrats 3 hervor. Vorzugsweise ist ein Abschnitt 11a der ersten Federelements 11 in Form eines durch in die Kondensatorhaltelementgrundplatte 7c eingebrachte Schlitze 11c gebildeten Bereichs der Deckplatte 7c ausgebildet.

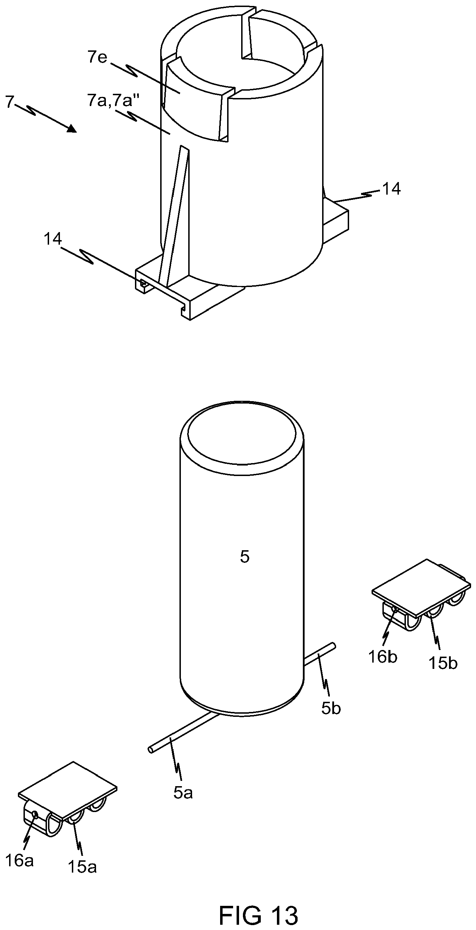

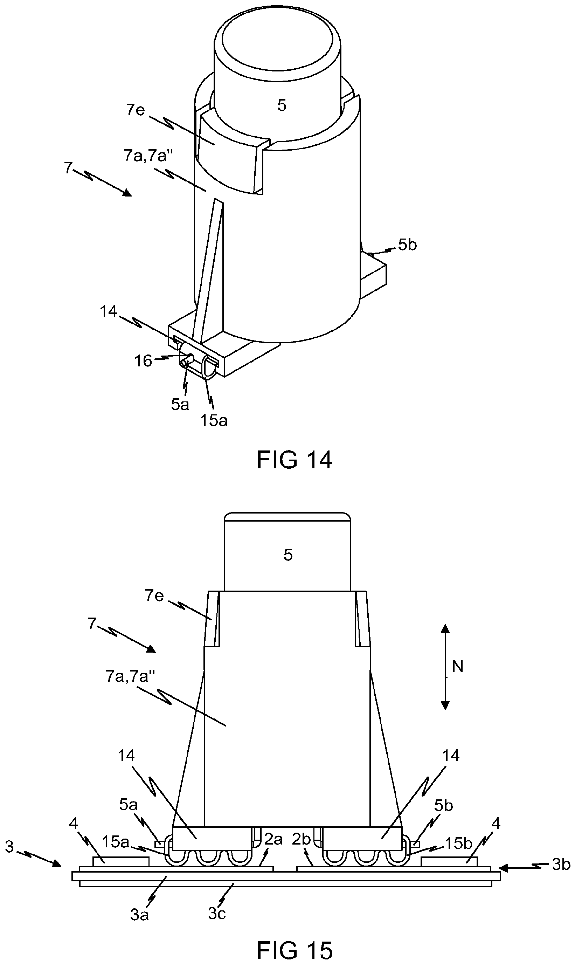

In den Figuren 13 bis 15 sind verschiedene Ansichten einer dritten Ausbildung einer erfindungsgemäßen Leistungshalbleitereinrichtung 1 dargestellt, die mit der ersten Ausbildung einer erfindungsgemäßen Leistungshalbleitereinrichtung 1 zumindest hinsichtlich der Ausbildung des Substrats 3, der Kondensatoren 5, der Grundplatte 9, der Leistungshalbleiterbauelemente 4 und der Druckerzeugungsmittel 17 übereinstimmt, wobei in den Figuren 13 bis 15 das Kondensatorhaltelement 7 nicht vollständig dargestellt ist, sondern der Übersichtlichkeit halber nur eine Aufnahmeeinrichtung 7a des Kondensatorhaltelements 7 zur Aufnahme eines Kondensators 5 und eine jeweilige Aufnahmeeinrichtung 14 des Kondensatorhaltelements 7 zur Aufnahme eines jeweiligen Federelements 15a bzw. 15b dargestellt sind. Selbstverständlich kann das Kondensatorhaltelement 7, analog wie z.B. in FIG 1 dargestellt, mehrere der in den Figuren 13 bis 15 dargestellten Aufnahmeeinrichtungen 7a aufweisen, so dass das Kondensatorhaltelement 7 auch mehrere Kondensatoren 5 aufnehmen bzw. halten kann.

Die gemäß der dritten Ausbildung der erfindungsgemäßen Leistungshalbleitereinrichtung ausgebildete Leistungshalbleitereinrichtung 1 weist ein erstes und einem zweites Federelement 15a und 15b auf. Der Kondensator 5 ist in der Aufnahmeeinrichtung 7a des Kondensatorhaltelements 7 angeordnet. Die Aufnahmeeinrichtung 7a weist vorzugsweise ein hüsenförmiges Rahmenelement 7a" auf, das den Kondensator 5 lateral umschließt, wobei die Aufnahmeeinrichtung 7a auch mehrere Rahmenelemente 7a" aufweisen kann, die den Kondensator 5 zumindest teilweise lateral umschließen (siehe analog FIG 1). Weiterhin weist die Aufnahmeeinrichtung 7a vorzugweise Rahmendruckelemente 7e auf, die lateral auf den Kondensator 5 drücken und solchermaßen den Kondensator 5 in der Aufnahmeeinrichtung 7a fixieren.

Das erste Federelement 15a weist einen elektrisch leitenden Kontakt mit dem ersten Kondensatoranschlusselement 5a auf und das zweite Federelement 15b weist einen elektrisch leitenden Kontakt mit dem zweiten Kondensatoranschlusselement 5b auf. Der jeweilige elektrisch leitende Kontakt kann, wie beim Ausführungsbeispiel als elektrisch leitender Druckkontakt, oder als elektrisch leitender stoffschlüssiger Kontakt, insbesondere als Schweißverbindung, ausgebildet sein.

Das Kondensatorhalteelement 7 weist vorzugsweise eine dem jeweiligen Federelement 15a bzw. 15b zugeordnete Aufnahmeeinrichtung 14 zur Aufnahme des jeweiligen Federelements 15a bzw. 15b auf, wobei ein jeweiliger Abschnitt des ersten und zweiten Federelements 15a bzw. 15b in der dem jeweiligen Federelement 15a bzw. 15b zugeordneten Aufnahmeeinrichtung 14 angeordnet ist. Das erste Federelement 15a weist vorzugsweise mindestens eine Öffnung 16a auf durch die ein Abschnitt des ersten Kondensatoranschlusselements 5a hindurchverläuft und das zweite Federelement 15b weist mindestens eine Öffnung 16b auf durch die ein Abschnitt des zweiten Kondensatoranschlusselements 5b hindurchverläuft.

Die Leistungshalbleitereinrichtung 1 ist derart ausgebildet, dass das Kondensatorhaltelement 7 das erste Federelement 15a, vorzugsweise in Normalenrichtung N des Substrats 3, gegen die erste Kontaktfläche 2a des Substrats 3 drückt, so dass das erste Federelement 15a mit der ersten Kontaktfläche 2a des Substrats 3 elektrisch leitend druckkontaktiert ist und dass das Kondensatorhaltelement 7 das zweite Federelement 15b, vorzugsweise in Normalenrichtung N des Substrats 3, gegen die zweite Kontaktfläche 2b des Substrats 3 drückt, so dass das zweite Federelement 15b mit der zweiten Kontaktfläche 2b des Substrats 3 elektrisch leitend druckkontaktiert ist.

Durch die ersten und zweiten Federelemente 15a und 15b können mechanische Stoß- und/oder Schwingungsbelastungen der Leistungshalbleitereinrichtung 1, welche auf den Kondensator 5 und das Substrat 3 einwirken und zu Bewegungen dieser Elemente führen, mechanisch durch die Federwirkung der ersten und zweiten Federelemente 15a und 15b ausgeglichen werden, so dass es bei Auftreten von mechanischen Stoß- und/oder Schwingungsbelastungen der Leistungshalbleitereinrichtung 1, zu keinem Versagen der elektrischen Verbindung der Kondensatoren 5 mit dem Substrat 3 kommt.

Die Leistungshalbleitereinrichtung 1 weist weiterhin, in analoger Weise wie in FIG 1 und FIG 2 dargestellt, vorzugsweise eine Grundplatte 9 und ein Druckerzeugungsmittel 17 auf, wobei das Substrat 3 zwischen der Aufnahmeeinrichtung 7a des Kondensatorhaltelements 7 und der Grundplatte 9 angeordnet ist und das Kondensatorhaltelement 7 mittels des Druckerzeugungsmittels 17 an der Grundplatte 9 befestigt ist, wobei das Druckerzeugungsmittel 17, vorzugsweise in Normalenrichtung N des Substrats 3, Druck auf das Kondensatorhaltelement 7 in Richtung auf das Substrat 3 zu ausübt und hierdurch das Kondensatorhaltelement 7 das erste Federelement 15a gegen die erste Kontaktfläche 2a des Substrats 3 drückt und das zweite Federelement 15b gegen die zweite Kontaktfläche 2b des Substrats 3 drückt.

Im Rahmen aller Ausführungsbeispiele sind die Leistungshalbleiterbauelemente 4 vorzugsweise elektrisch zu Halbbrückenschaltungen verschalten, die z.B. zum Gleich- und Wechselrichten von elektrischen Spannungen und Strömen verwendet werden können. Der Übersichtlichkeit halber sind in den Figuren Bonddrähte oder ein elektrisch leitender Folienverbund, die die Leistungshalbleiterbauelemente 4 elektrisch leitend miteinander verbinden, nicht dargestellt. Die Leistungshalbleitereinrichtung 1 weist als Energiespeicher die Kondensatoren 5 auf, die eine an der Leistungshalbleitereinrichtung 1 anliegende Gleichspannung puffern. Die Kondensatoren 5 dienen bei den Ausführungsbeispielen solchermaßen als Zwischenkreiskondensatoren, sie können jedoch auch einem anderen Zweck dienen.

Es sei angemerkt, dass die bezüglich der Ausführungsbeispiele im Singular genannten Elemente der Leistungshalbleitereinrichtung 1 selbstverständlich auch mehrfach bei der Erfindung vorhanden sein können.

Es sei weiterhin angemerkt, dass selbstverständlich Merkmale von verschiedenen Ausführungsbeispielen der Erfindung, sofern sich die Merkmale nicht gegenseitig ausschließen, beliebig miteinander kombiniert werden können.

## Patentansprüche

1. Leistungshalbleitereinrichtung mit einem eine erste und eine zweite elektrisch leitende Kontaktfläche (2a,2b) aufweisenden Substrat (3) auf dem Leistungshalbleiterbauelemente (4) angeordnet und mit dem Substrat (3) elektrisch leitend verbunden sind, und mit einem elektrischen Kondensator (5), der zum elektrischen Anschluss des Kondensators (5) ein elektrisch leitendes erstes und ein elektrisch leitendes zweites Kondensatoranschlusselement (5a,5b) aufweist, und mit einem ersten und einem zweiten Druckelement (6a,6b), wobei ein erster Abschnitt (5a') des ersten Kondensatoranschlusselements (5a) zwischen dem ersten Druckelement (6a) und der ersten Kontaktfläche (2a) des Substrats (3) angeordnet ist und ein erster Abschnitt (5b') des zweiten Kondensatoranschlusselements (5b) zwischen dem zweiten Druckelement (6b) und der zweiten Kontaktfläche (2b) des Substrats (3) angeordnet ist, wobei die Leistungshalbleitereinrichtung (1) derart ausgebildet ist, dass das erste Druckelement (6a) den ersten Abschnitt (5a') des ersten Kondensatoranschlusselements (5a) gegen die erste Kontaktfläche (2a) des Substrats (3) drückt, so dass das erste Kondensatoranschlusselement (5a) mit der ersten Kontaktfläche (2a) des Substrats (3) elektrisch leitend druckkontaktiert ist, und dass das zweite Druckelement (6b) den ersten Abschnitt (5b') des zweiten Kondensatoranschlusselements (5b) gegen die zweite Kontaktfläche (2b) des Substrats (3) drückt, so dass das zweite Kondensatoranschlusselement (5b) mit der zweiten Kontaktfläche (2b) des Substrats (3) elektrisch leitend druckkontaktiert ist.

2. Leistungshalbleitereinrichtung nach Anspruch 1, **dadurch gekennzeichnet, dass** die Leistungshalbleitereinrichtung (1) ein, eine Aufnahmeeinrichtung (7a) zur Aufnahme des Kondensators (5) aufweisendes Kondensatorhalteelement (7) aufweist, wobei der Kondensator (5) in der Aufnahmeeinrichtung (7a) des Kondensatorhaltelements (7) angeordnet ist, wobei das erste und zweite Druckelement (6a,6b) mit dem Kondensatorhaltelement (7) einstückig ausgebildet sind oder ein jeweiliger Abschnitt des ersten und zweiten Druckelements (6a,6b) in das Kondensatorhalteelement (7) eingespritzt ist oder ein jeweiliger Abschnitt des ersten und zweiten Druckelements (6a,6b) in einer jeweilig zugeordneten Ausnehmung (7d) des Kondensatorhalteelements (7) angeordnet ist.

3. Leistungshalbleitereinrichtung nach einem der vorhergehenden Ansprüchen, **dadurch gekennzeichnet dass** das erste und zweite Druckelement (6a,6b) in Normalenrichtung (N) des Substrats (3) federnd ausgebildet sind.

4. Leistungshalbleitereinrichtung nach Anspruch 2 oder 3, **dadurch gekennzeichnet, dass** die Aufnahmeeinrichtung (7a) ein Aufnahmehalteelement (7a') aufweist, wobei der Kondensator (5) in Normalenrichtung (N) des Substrats (3) zwischen dem Aufnahmehalteelement (7a') und dem Substrat (3) angeordnet ist.

5. Leistungshalbleitereinrichtung nach einer der Ansprüche 2 bis 4, **dadurch gekennzeichnet, dass** die Leistungshalbleitereinrichtung (1) eine Grundplatte (9) und ein Druckerzeugungsmittel (17) aufweist, wobei das Substrat (3) zwischen der Aufnahmeeinrichtung (7a) des Kondensatorhaltelements (7) und der Grundplatte (9) angeordnet ist und das Kondensatorhaltelement (7) mittels des Druckerzeugungsmittels (17) an der Grundplatte (9) befestigt ist, wobei das Druckerzeugungsmittel (17) Druck auf das Kondensatorhaltelement (7) in Richtung auf das Substrat (3) zu ausübt und hierdurch das erste Druckelement (6a) den ersten Abschnitt (5a') des ersten Kondensatoranschlusselements (7) gegen die erste Kontaktfläche (2a) des Substrats (3) drückt, so dass das erste Kondensatoranschlusselement (5a) mit der ersten Kontaktfläche (2a) des Substrats (3) elektrisch leitend druckkontaktiert ist, und das zweite Druckelement (6a) den ersten Abschnitt (5b') des zweiten Kondensatoranschlusselements (5b) gegen die zweite Kontaktfläche (2b) des Substrats (3) drückt, so dass das zweite Kondensatoranschlusselement (5b) mit der zweiten Kontaktfläche (2b) des Substrats (3) elektrisch leitend druckkontaktiert ist.

6. Leistungshalbleitereinrichtung nach Anspruch 1, **dadurch gekennzeichnet, dass** die Leistungshalbleitereinrichtung (1) ein, eine Aufnahmeeinrichtung (7a) zur Aufnahme des Kondensators (5) aufweisendes Kondensatorhalteelement (7) aufweist, wobei der Kondensator (5) in der Aufnahmeeinrichtung (7a) des Kondensatorhaltelements (7) in Normalenrichtung (N) des Substrats (3) beweglich angeordnet ist, wobei das erste Druckelement (6a) mit dem zweiten Druckelement (6b) einstückig ausgebildet ist, wobei das erste und zweite Druckelement (6a,6b) integraler Bestandteil eines zwischen dem Kondensatorhaltelement (7) und dem Substrat (3) angeordneten Andruckelements (6) sind, wobei die Leistungshalbleitereinrichtung (1) ein erstes Federelement (8,8') aufweist, wobei der Kondensator (5) in Normalenrichtung des Substrats (3) zwischen dem ersten Federelement (8,8') und dem Andruckelement (6) angeordnet ist, wobei das erste Federelement (8,8') den Kondensator (5) in Normalenrichtung (N) des Substrats (3) gegen das Andruckelement (6) drückt und hierdurch das erste Druckelement (6a) den ersten Abschnitt (5a') des ersten Kondensatoranschlusselements (5a) gegen die erste Kontaktfläche (2a) des Substrats (3) drückt, so dass das erste Kondensatoranschlusselement (5a) mit der ersten Kontaktfläche (2a) des Substrats (3) elektrisch leitend druckkontaktiert ist, und das zweite Druckelement (6b) den ersten Abschnitt (5b') des zweiten Kondensatoranschlusselements (5b) gegen die zweite Kontaktfläche (2b) des Substrats (3) drückt, so dass das zweite Kondensatoranschlusselement (5b) mit der zweiten Kontaktfläche (2b) des Substrats (3) elektrisch leitend druckkontaktiert ist.

7. Leistungshalbleitereinrichtung nach Anspruch 6, **dadurch gekennzeichnet, dass** die Leistungshalbleitereinrichtung (1) eine Grundplatte (9) und ein Druckerzeugungsmittel (17) aufweist, wobei das Substrat (3) zwischen der Aufnahmeeinrichtung (7a) des Kondensatorhaltelements (7) und der Grundplatte (9) angeordnet ist, wobei das erste Federelement (8) mit dem Kondensatorhaltelement (7) einstückig ausgebildet ist, wobei das Kondensatorhaltelement (7) mittels des Druckerzeugungsmittels (17) an der Grundplatte (9) befestigt ist, wobei das Druckerzeugungsmittel (17) Druck auf das Kondensatorhaltelement (7) in Richtung auf das Substrat (3) zu und damit Druck auf das erste Federelement (8) in Richtung auf den Kondensator (5) zu ausübt.

8. Leistungshalbleitereinrichtung nach Anspruch 6, **dadurch gekennzeichnet, dass** die Leistungshalbleitereinrichtung (1) eine Grundplatte (9) und ein Druckerzeugungsmittel (17) aufweist, wobei das Substrat (3) zwischen der Aufnahmeeinrichtung (7a) des Kondensatorhaltelements (7) und der Grundplatte (9) angeordnet ist, wobei zumindest ein Abschnitt (8a') des ersten Federelements (8') in Form eines durch in eine Deckplatte (12) eingebrachte Schlitze (13) gebildeten Bereichs der Deckplatte (12) ausgebildet ist, wobei die Deckplatte (12) mit dem Kondensatorhaltelement (7) verbundenen ist, wobei das Kondensatorhaltelement (7) mittels des Druckerzeugungsmittels (17) an der Grundplatte (9) befestigt ist, wobei das Druckerzeugungsmittel (17) Druck auf das Kondensatorhaltelement (7) in Richtung auf das Substrat (3) zu und damit Druck auf das erste Federelement (8') in Richtung auf den Kondensator (5) zu ausübt.

9. Leistungshalbleitereinrichtung nach Anspruch 7 oder 8, **dadurch gekennzeichnet, dass** das Kondensatorhaltelement (7) an seiner dem Substrat (3) zugewandten Seite (7") in Richtung des Substrats (3) hervorstehende zweite Federelemente (11) aufweist, wobei die zweiten Federelemente (11) das Substrat (3) gegen die Grundplatte (9) drücken.

10. Leistungshalbleitereinrichtung mit einem eine erste und eine zweite elektrisch leitende Kontaktfläche (2a,2b) aufweisenden Substrat (3) auf dem Leistungshalbleiterbauelemente (4) angeordnet und mit dem Substrat (3) elektrisch leitend verbunden sind, und mit einem elektrischen Kondensator (5), der zum elektrischen Anschluss des Kondensators (5) ein elektrisch leitendes erstes und ein elektrisch leitendes zweites Kondensatoranschlusselement (5a,5b) aufweist, und mit einem ersten und einem zweiten Federelement (15a,15b), und mit einem eine Aufnahmeeinrichtung (7a) zur Aufnahme des Kondensators (5) aufweisenden Kondensatorhalteelement (7), wobei der Kondensator (5) in der Aufnahmeeinrichtung (7a) des Kondensatorhaltelements (7) angeordnet ist, wobei das erste Federelement (15a) einen elektrisch leitenden Kontakt mit dem ersten Kondensatoranschlusselement (5a) aufweist und das zweite Federelement (15b) einen elektrisch leitenden Kontakt mit dem zweiten Kondensatoranschlusselement (5b) aufweist, wobei die Leistungshalbleitereinrichtung (1) derart ausgebildet ist, dass das Kondensatorhaltelement (7) das erste Federelement (15a) gegen die erste Kontaktfläche (2a) des Substrats (3) drückt, so dass das erste Federelement (15a) mit der ersten Kontaktfläche (2a) des Substrats (3) elektrisch leitend druckkontaktiert ist und dass das Kondensatorhaltelement (7) das zweite Federelement (15b) gegen die zweite Kontaktfläche (2b) des Substrats (3) drückt, so dass das zweite Federelement (15b) mit der zweiten Kontaktfläche (2b) des Substrats (3) elektrisch leitend druckkontaktiert ist.

11. Leistungshalbleitereinrichtung nach Anspruch 10, **dadurch gekennzeichnet, dass** Kondensatorhalteelement (7) eine dem jeweiligen Federelement (15a,15b) zugeordnete Aufnahmeeinrichtung (14) zur Aufnahme des jeweiligen Federelements (15a,15b) aufweist, wobei ein jeweiliger Abschnitt des ersten und zweiten Federelements (15a,15b) in der dem jeweiligen Federelement (15a,15b) zugeordneten Aufnahmeeinrichtung (14) angeordnet ist.

12. Leistungshalbleitereinrichtung nach Anspruch 10 oder 11, **dadurch gekennzeichnet, dass** das erste Federelement (15a) mindestens eine Öffnung (16a) aufweist durch die ein Abschnitt des ersten Kondensatoranschlusselements (5a) hindurchverläuft und dass das zweite Federelement (15b) mindestens eine Öffnung (16b) aufweist durch die ein Abschnitt des zweiten Kondensatoranschlusselements (5b) hindurchverläuft.

13. Leistungshalbleitereinrichtung nach einem der Ansprüche 10 bis 12, **dadurch gekennzeichnet, dass** der elektrisch leitende Kontakt des ersten Federelements (15a) mit dem ersten Kondensatoranschlusselement (5a) und der elektrisch leitende Kontakt des zweiten Federelements (15b) mit dem zweiten Kondensatoranschlusselement (5b) jeweilig als elektrisch leitender Druckkontakt oder als elektrisch leitender stoffschlüssiger Kontakt ausgebildet ist.

14. Leistungshalbleitereinrichtung nach einem der Ansprüche 10 bis 13, **dadurch gekennzeichnet, dass** die Leistungshalbleitereinrichtung (1) eine Grundplatte (9) und ein Druckerzeugungsmittel (17) aufweist, wobei das Substrat (3) zwischen der Aufnahmeeinrichtung (7a) des Kondensatorhaltelements (7) und der Grundplatte (9) angeordnet ist und das Kondensatorhaltelement (7) mittels des Druckerzeugungsmittels (17) an der Grundplatte (9) befestigt ist, wobei das Druckerzeugungsmittel (17) Druck auf das Kondensatorhaltelement (7) in Richtung auf das Substrat (3) zu ausübt und hierdurch das Kondensatorhaltelement (7) das erste Federelement (15a) gegen die erste Kontaktfläche (2a) des Substrats (3) drückt und das zweite Federelement (15b) gegen die zweite Kontaktfläche (2b) des Substrats (3) drückt.

15. Leistungshalbleitereinrichtung nach Anspruch 5 oder nach einem der Ansprüche 7 bis 9 oder nach Anspruch 14, **dadurch gekennzeichnet, dass** das Substrat (3) gegen die Grundplatte (9) drückt und hierdurch das Substrat (3) mit der Grundplatte (9) kraftschlüssig verbunden ist.

16. Leistungshalbleitereinrichtung nach Anspruch 5 oder nach einem der Ansprüche 7 bis 9 oder nach Anspruch 14 oder 15, **dadurch gekennzeichnet, dass** das Druckerzeugungsmittel (17) als mindestens eine Schraubverbindung ausgebildet ist.

17. Leistungshalbleitereinrichtung nach einem der vorhergehenden Ansprüchen **dadurch gekennzeichnet, dass** Substrat (3) als Direct Copper Bonded Substrat oder als Insulated Metal Substrat ausgebildet ist.

## Claims

1. Power semiconductor device comprising a substrate (3) which has a first and a second electrically conductive contact area (2a, 2b) and on which power semiconductor components (4) are arranged and are electrically conductively connected to the substrate (3), and comprising an electrical capacitor (5) which, for electrical connection of the capacitor (5), has an electrically conductive first and an electrically conductive second capacitor connection element (5a, 5b), and comprising a first and a second pressure element (6a, 6b), wherein a first section (5a') of the first capacitor connection element (5a) is arranged between the first pressure element (6a) and the first contact area (2a) of the substrate (3), and a first section (5b') of the second capacitor connection element (5b) is arranged between the second pressure element (6b) and the second contact area (2b) of the substrate (3), wherein the power semiconductor device (1) is formed in such a way that the first pressure element (6a) presses the first section (5a') of the first capacitor connection element (5a) against the first contact area (2a) of the substrate (3), so that the first capacitor connection element (5a) is electrically conductively pressure-contact-connected to the first contact area (2a) of the substrate (3), and that the second pressure element (6b) presses the first section (5b') of the second capacitor connection element (5b) against the second contact area (2b) of the substrate (3), so that the second capacitor connection element (5b) is electrically conductively pressure-contact-connected to the second contact area (2b) of the substrate (3).

2. Power semiconductor device according to Claim 1, **characterized in that** the power semiconductor device (1) has a capacitor holding element (7) which has a receptacle device (7a) for receiving the capacitor (5), wherein the capacitor (5) is arranged in the receptacle device (7a) of the capacitor holding element (7), wherein the first and the second pressure element (6a, 6b) are integrally formed with the capacitor holding element (7) or a respective section of the first and the second pressure element (6a, 6b) is injection-moulded into the capacitor holding element (7) or a respective section of the first and the second pressure element (6a, 6b) is arranged in a respectively associated recess (7d) in the capacitor holding element (7).

3. Power semiconductor device according to either of the preceding claims, **characterized in that** the first and the second pressure element (6a, 6b) are formed with a spring action in the normal direction (N) of the substrate (3).

4. Power semiconductor device according to Claim 2 or 3, **characterized in that** the receptacle device (7a) has a receptacle holding element (7a'), wherein the capacitor (5) is arranged between the receptacle holding element (7a') and the substrate (3) in the normal direction (N) of the substrate (3).

5. Power semiconductor device according to one of Claims 2 to 4, **characterized in that** the power semiconductor device (1) has a base plate (9) and a pressure-generating means (17), wherein the substrate (3) is arranged between the receptacle device (7a) of the capacitor holding element (7) and the base plate (9), and the capacitor holding element (7) is fastened to the base plate (9) by means of the pressure-generating means (17), wherein the pressure-generating means (17) exerts pressure onto the capacitor holding element (7) in the direction of the substrate (3) and, as a result, the first pressure element (6a) pushes the first section (5a') of the first capacitor connection element (7) against the first contact area (2a) of the substrate (3), so that the first capacitor connection element (5a) is electrically conductively pressure-contact-connected to the first contact area (2a) of the substrate (3), and the second pressure element (6a) presses the first section (5b') of the second capacitor connection element (5b) against the second contact area (2b) of the substrate (3), so that the second capacitor connection element (5b) is electrically conductively pressure-contact-connected to the second contact area (2b) of the substrate (3).

6. Power semiconductor device according to Claim 1, **characterized in that** the power semiconductor device (1) has a capacitor holding element (7) which has a receptacle device (7a) for receiving the capacitor (5), wherein the capacitor (5) is arranged in the receptacle device (7a) of the capacitor holding element (7) such that it can move in the normal direction (N) of the substrate (3), wherein the first pressure element (6a) is integrally formed with the second pressure element (6b), wherein the first and the second pressure element (6a, 6b) are an integral constituent part of a contact-pressure element (6) which is arranged between the capacitor holding element (7) and the substrate (3), wherein the power semiconductor device (1) has a first spring element (8, 8'), wherein the capacitor (5) is arranged between the first spring element (8, 8') and the contact-pressure element (6) in the normal direction of the substrate (3), wherein the first spring element (8, 8') presses the capacitor (5) against the contact-pressure element (6) in the normal direction (N) of the substrate (3) and as a result the first pressure element (6a) presses the first section (5a') of the first capacitor connection element (5a) against the first contact area (2a) of the substrate (3), so that the first capacitor connection element (5a) is electrically conductively pressure-contact-connected to the first contact area (2a) of the substrate (3), and the second pressure element (6b) presses the first section (5b') of the second capacitor connection element (5b) against the second contact area (2b) of the substrate (3), so that the second capacitor connection element (5b) is electrically conductively pressure-contact-connected to the second contact area (2b) of the substrate (3).

7. Power semiconductor device according to Claim 6, **characterized in that** the power semiconductor device (1) has a base plate (9) and a pressure-generating means (17), wherein the substrate (3) is arranged between the receptacle device (7a) of the capacitor holding element (7) and the base plate (9), wherein the first spring element (8) is integrally formed with the capacitor holding element (7), wherein the capacitor holding element (7) is fastened to the base plate (9) by means of the pressure-generating means (17), wherein the pressure-generating means (17) exerts pressure onto the capacitor holding element (7) in the direction of the substrate (3) and therefore exerts pressure onto the first spring element (8) in the direction of the capacitor (5).

8. Power semiconductor device according to Claim 6, **characterized in that** the power semiconductor device (1) has a base plate (9) and a pressure-generating means (17), wherein the substrate (3) is arranged between the receptacle device (7a) of the capacitor holding element (7) and the base plate (9), wherein at least one section (8a') of the first spring element (8') is designed in the form of a region of a covering plate (12), which region is formed by slots (13) which are made in the covering plate (12), wherein the covering plate (12) is connected to the capacitor holding element (7), wherein the capacitor holding element (7) is fastened to the base plate (9) by means of the pressure-generating means (17), wherein the pressure-generating means (17) exerts pressure onto the capacitor holding element (7) in the direction of the substrate (3) and therefore exerts pressure onto the first spring element (8') in the direction of the capacitor (5).

9. Power semiconductor device according to Claim 7 or 8, **characterized in that** the capacitor holding element (7) has second spring elements (11) which project from that side (7") of the said capacitor holding element which faces the substrate (3) in the direction of the substrate (3), wherein the second spring elements (11) press the substrate (3) against the base plate (9).

10. Power semiconductor device comprising a substrate (3) which has a first and a second electrically conductive contact area (2a, 2b) and on which power semiconductor components (4) are arranged and are electrically conductively connected to the substrate (3), and comprising an electrical capacitor (5) which, for electrical connection of the capacitor (5), has an electrically conductive first and an electrically conductive second capacitor connection element (5a, 5b), and comprising a first and a second spring element (15a, 15b), and comprising a capacitor holding element (7) which has a receptacle device (7a) for receiving the capacitor (5), wherein the capacitor (5) is arranged in the receptacle device (7a) of the capacitor holding element (7), wherein the first spring element (15a) is in electrically conductive contact with the first capacitor connection element (5a) and the second spring element (15b) is in electrically conductive contact with the second capacitor connection element (5b), wherein the power semiconductor device (1) is formed in such a way that the capacitor holding element (7) presses the first spring element (15a) against the first contact area (2a) of the substrate (3), so that the first spring element (15a) is electrically conductively pressure-contact-connected to the first contact area (2a) of the substrate (3), and that the capacitor holding element (7) presses the second spring element (15b) against the second contact area (2b) of the substrate (3), so that the second spring element (15b) is electrically conductively pressure-contact-connected to the second contact area (2b) of the substrate (3).

11. Power semiconductor device according to Claim 10, **characterized in that** the capacitor holding element (7) has a receptacle device (14), which is associated with the respective spring element (15a, 15b), for receiving the respective spring element (15a, 15b), wherein a respective section of the first and the second spring element (15a, 15b) is arranged in the receptacle device (14) which is associated with the respective spring element (15a, 15b).

12. Power semiconductor device according to Claim 10 or 11, **characterized in that** the first spring element (15a) has at least one opening (16a) through which a section of the first capacitor connection element (5a) runs, and **in that** the second spring element (15b) has at least one opening (16b) through which a section of the second capacitor connection element (5b) runs.

13. Power semiconductor device according to one of Claims 10 to 12, **characterized in that** the electrically conductive contact of the first spring element (15a) with the first capacitor connection element (5a) and the electrically conductive contact of the second spring element (15b) with the second capacitor connection element (5b) are in each case in the form of an electrically conductive pressure contact or in the form of an electrically conductive cohesive contact.

14. Power semiconductor device according to one of Claims 10 to 13, **characterized in that** the power semiconductor device (1) has a base plate (9) and a pressure-generating means (17), wherein the substrate (3) is arranged between the receptacle device (7a) of the capacitor holding element (7) and the base plate (9), and the capacitor holding element (7) is fastened to the base plate (9) by means of the pressure-generating means (17), wherein the pressure-generating means (17) exerts pressure onto the capacitor holding element (7) in the direction of the substrate (3) and as a result the capacitor holding element (7) presses the first spring element (15a) against the first contact area (2a) of the substrate (3) and the second spring element (15b) against the second contact area (2b) of the substrate (3).

15. Power semiconductor device according to Claim 5 or according to one of Claims 7 to 9 or according to Claim 14, **characterized in that** the substrate (3) presses against the base plate (9) and as a result the substrate (3) is connected in a force-fitting manner to the base plate (9).

16. Power semiconductor device according to Claim 5 or according to one of Claims 7 to 9 or according to Claim 14 or 15, **characterized in that** the pressure-generating means (17) is in the form of at least one screw connection.

17. Power semiconductor device according to one of the preceding claims, **characterized in that** the substrate (3) is in the form of a direct copper bonded substrate or in the form of an insulated metal substrate.

## Revendications

1. Dispositif semi-conducteur de puissance doté d'un substrat (3) comprenant une première et une deuxième surface de contact électriquement conductrice (2a, 2b), agencées sur le composant semi-conducteur de puissance (4) et connectées au substrat (3) par des connexions électriquement conductrices, et doté d'un condensateur électrique (5), le condensateur électrique (5) comporte un premier et un deuxième élément de raccord de condensateur électriquement conducteur (5a, 5b) pour raccorder le condensateur, et doté d'un premier et d'un deuxième élément de pression (6a, 6b), dans lequel une première section (5a') du premier élément de raccord de condensateur (5a) est agencée entre le premier élément de pression (6a) et la première surface de contact (2a) du substrat (3) et une première section (5b') du deuxième élément de raccord de condensateur (5b) est agencée entre le deuxième élément de pression (6b) et la deuxième surface de contact (2b) du substrat (3), dans lequel le dispositif semi-conducteur de puissance (1) est conçu de telle sorte que le premier élément de pression (6a) presse la première section (5a') du premier élément de raccord de condensateur (5a) contre la première surface de contact (2a) du substrat (3), de façon à ce que le premier élément de raccord de condensateur (5a) soit en contact par pression électriquement conducteur avec la première surface de contact (2a) du substrat (3), et que le deuxième élément de pression (6b) presse la première section (5b') du deuxième élément de raccord de condensateur (5b) contre la deuxième surface de contact (2b) du substrat (3), de façon à ce que le deuxième élément de raccord de condensateur (5b) soit en contact par pression électriquement conducteur avec la deuxième surface de contact (2b) du substrat (3).

2. Dispositif semi-conducteur de puissance selon la revendication 1, **caractérisé en ce que** le dispositif semi-conducteur de puissance (1) comporte un élément de support de condensateur (7) comportant un dispositif d'accueil (7a) destiné à accueillir le condensateur (5), dans lequel le condensateur (5) est agencé dans le dispositif d'accueil (7a) de l'élément de support de condensateur (7), dans lequel le premier et le deuxième élément de pression (6a, 6b) sont conçus d'une seule pièce avec l'élément de support de condensateur (7) ou des sections respectives du premier et du deuxième élément de pression (6a, 6b) sont injectées dans l'élément de support de condensateur (7) ou des sections respectives du premier et du deuxième élément de pression (6a, 6b) sont agencées dans une cavité (7d) de l'élément de support de condensateur (7).

3. Dispositif semi-conducteur de puissance selon l'une des revendications précédentes, **caractérisé en ce que** le premier et le deuxième élément de pression (6a, 6b) sont conçus de manière élastique dans la direction normale (N) du substrat (3).

4. Dispositif semi-conducteur de puissance selon la revendication 2 ou 3, **caractérisé en ce que** le dispositif d'accueil (7a) comporte un élément d'accueil (7a'), dans lequel le condensateur (5) est agencé entre l'élément d'accueil (7a') et le substrat (3) dans la direction normale (N) du substrat (3).

5. Dispositif semi-conducteur de puissance selon l'une des revendications 2 à 4, **caractérisé en ce que** le dispositif semi-conducteur de puissance (1) comporte un socle (9) et un moyen de production de pression (17), dans lequel le substrat (3) est agencé entre le dispositif d'accueil (7a) de l'élément de support de condensateur (7) et le socle (9) et l'élément de support de condensateur (7) est fixé au socle (9) par le biais du moyen de production de pression (17), dans lequel le moyen de production de pression (17) exerce une pression sur l'élément de support de condensateur (7) vers le substrat (3) et par conséquent le premier élément de pression (6a) presse la première section (5a') du premier élément de support de condensateur (7) contre la première surface de contact (2a) du substrat (3), de façon à ce que le premier élément de raccord de condensateur (5a) soit en contact par pression électriquement conducteur avec la première surface de contact (2a) du substrat (3), et que le deuxième élément de pression (6a) presse la première section (5b') du deuxième élément de raccord de condensateur (5b) contre la deuxième surface de contact (2b) du substrat (3), de façon à ce que le deuxième élément de raccord de condensateur (5b) soit en contact par pression électriquement conducteur avec la deuxième surface de contact (2b) du substrat (3).

6. Dispositif semi-conducteur de puissance selon la revendication 1, **caractérisé en ce que** le dispositif semi-conducteur de puissance (1) comporte un élément de support de condensateur (7) comportant un dispositif d'accueil (7a) destiné à accueillir le condensateur (5), dans lequel le condensateur (5) est agencé dans le dispositif d'accueil (7a) de l'élément de support de condensateur (7) de façon mobile dans la direction normale (N) du substrat (3), dans lequel le premier élément de pression (6a) est conçu d'une pièce avec le deuxième élément de pression (6b), dans lequel le premier et le deuxième élément de pression (6a, 6b) sont parties intégrantes d'un élément presseur (6) agencé entre l'élément de support de condensateur (7) et le substrat (3), dans lequel le dispositif semi-conducteur de puissance (1) comporte un premier élément de ressort (8, 8'), dans lequel le condensateur (5) est agencé entre le premier élément de ressort (8, 8') et l'élément presseur (6) dans la direction normale du substrat (3), dans lequel le premier élément de ressort (8, 8') presse le condensateur (5) contre l'élément presseur (6) dans la direction normale (N) du substrat (3) et par conséquent le premier élément de pression (6a) presse la première section (5a') du premier élément de raccord de condensateur (5a) contre la première surface de contact (2a) du substrat (3), de façon à ce que le premier élément de raccord de condensateur (5a) soit en contact par pression électriquement conducteur avec la première surface de contact (2a) du substrat (3), et que le deuxième élément de pression (6b) presse la première section (5b') du deuxième élément de raccord de condensateur (5b) contre la deuxième surface de contact (2b) du substrat (3), de façon à ce que le deuxième élément de raccord de condensateur (5b) soit en contact par pression électriquement conducteur avec la deuxième surface de contact (2b) du substrat (3).

7. Dispositif semi-conducteur de puissance selon la revendication 6, **caractérisé en ce que** le dispositif semi-conducteur de puissance (1) comporte un socle (9) et un moyen de production de pression (17), dans lequel le substrat (3) est agencé entre le dispositif d'accueil (7a) de l'élément de support de condensateur (7) et le socle (9), dans lequel le premier élément de ressort (8) est conçu d'une pièce avec l'élément de support de condensateur (7), dans lequel l'élément de support de condensateur (7) est fixé au socle (9) par le moyen de production de pression (17), dans lequel le moyen de production de pression (17) exerce une pression sur l'élément de support de condensateur (7) vers le substrat (3) et exerce une pression ainsi sur le premier élément de ressort (8) vers le condensateur (5).

8. Dispositif semi-conducteur de puissance selon la revendication 6, **caractérisé en ce que** le dispositif semi-conducteur de puissance (1) comporte un socle (9) et un moyen de production de pression (17), dans lequel le substrat (3) est agencé entre le dispositif d'accueil (7a) de l'élément de support de condensateur (7) et le socle (9), dans lequel au moins une section (8a') du premier élément de ressort (8') est conçue sous forme d'une zone formée par une fente (13) dans une plaque de recouvrement (12), dans lequel la plaque de recouvrement (12) est connectée à l'élément de support de condensateur (7), dans lequel l'élément de support de condensateur (7) est fixé au socle (9) par le moyen de production de pression (17), dans lequel le moyen de production de pression (17) exerce une pression sur l'élément de support de condensateur (7) vers le substrat (3) et exerce une pression ainsi sur le premier élément de ressort (8') vers le condensateur (5).

9. Dispositif semi-conducteur de puissance selon la revendication 7 ou 8, **caractérisé en ce que** l'élément de support de condensateur (7) comporte des deuxièmes éléments de ressort (11) sur son côté (7") faisant face au substrat (3) et saillant dans la direction du substrat (3), dans lequel les deuxièmes éléments de ressort (11) pressent le substrat (3) contre le socle (9).

10. Dispositif semi-conducteur de puissance doté d'un substrat (3) comprenant une première et une deuxième surface de contact électriquement conductrice (2a, 2b), agencées sur le composant semi-conducteur de puissance (4) et connectées au substrat (3) par des connexions électriquement conductrices, et doté d'un condensateur électrique (5), le condensateur électrique (5) comporte un premier et un deuxième élément de raccord de condensateur électriquement conducteur (5a, 5b) pour raccorder le condensateur, et doté d'un premier et d'un deuxième élément de ressort (15a, 15b), et doté d'un élément de support de condensateur (7) comportant un dispositif d'accueil (7a) destiné à accueillir le condensateur (5), dans lequel le condensateur (5) est agencé dans le dispositif d'accueil (7a) de l'élément de support de condensateur (7), dans lequel le premier élément de ressort (15a) comporte un contact électriquement conducteur avec le premier élément de raccord de condensateur (5a) et le deuxième élément de ressort (15b) comporte un contact électriquement conducteur avec le deuxième élément de raccord de condensateur (5b), dans lequel le dispositif semi-conducteur de puissance (1) est conçu de telle sorte que l'élément de support de condensateur (7) presse le premier élément de ressort (15a) contre la première surface de contact (2a) du substrat (3), de façon à ce que le premier élément de ressort (15a) soit en contact par pression électriquement conducteur avec la première surface de contact (2a) du substrat (3), et que l'élément de support de condensateur (7) presse le deuxième élément de ressort (15b) contre la deuxième surface de contact (2b) du substrat (3), de façon à ce que le deuxième élément de ressort (15b) soit en contact par pression électriquement conducteur avec la deuxième surface de contact (2b) du substrat (3).

11. Dispositif semi-conducteur de puissance selon la revendication 10, **caractérisé en ce que** l'élément de support de condensateur (7) comporte un dispositif d'accueil (14) ordonné à l'élément de ressort (15a, 15b) respectif pour l'accueil de l'élément de ressort (15a, 15b) respectif, dans lequel une section respective du premier et du deuxième élément de ressort (15a, 15b) est agencée dans le dispositif d'accueil (14) ordonné à l'élément de ressort (15a, 15b) respectif.

12. Dispositif semi-conducteur de puissance selon la revendication 10 ou 11, **caractérisé en ce que** le premier élément de ressort (15a) comporte au moins une ouverture (16a) à travers laquelle passe une section du premier élément de raccord de condensateur (5a) et **en ce que** le deuxième élément de ressort (15b) comporte au moins une ouverture (16b) à travers laquelle passe une section du deuxième élément de raccord de condensateur (5b).

13. Dispositif semi-conducteur de puissance selon l'une des revendications 10 à 12, **caractérisé en ce que** le contact électriquement conducteur du premier élément de ressort (15a) avec le premier élément de raccord de condensateur (5a) et le contact électriquement conducteur du deuxième élément de ressort (15b) avec le deuxième élément de raccord de condensateur (5b) sont conçus respectivement comme contacts de pression électriquement conducteurs ou comme contacts par adhérence de matériau électriquement conducteurs.

14. Dispositif semi-conducteur de puissance selon l'une des revendications 10 à 13, **caractérisé en ce que** le dispositif semi-conducteur de puissance (1) comporte un socle (9) et un moyen de production de pression (17), dans lequel le substrat (3) est agencé entre le dispositif d'accueil (7a) de l'élément de support de condensateur (7) et le socle (9) et l'élément de support de condensateur (7) est fixé au socle (9) par le biais du moyen de production de pression (17), dans lequel le moyen de production de pression (17) exerce une pression sur l'élément de support de condensateur (7) vers le substrat (3) et par conséquent l'élément de support de condensateur (7) presse le premier élément de ressort (15a) contre la première surface de contact (2a) du substrat (3) et presse le deuxième élément de ressort (15b) contre la deuxième surface de contact (2b) du substrat (3).

15. Dispositif semi-conducteur de puissance selon la revendication 5 ou selon l'une des revendications 7 à 9 ou selon la revendication 14, **caractérisé en ce que** le substrat (3) presse contre le socle (9) et par conséquent le substrat (3) est connecté au socle (9) par engagement par force.

16. Dispositif semi-conducteur de puissance selon la revendication 5 ou selon l'une des revendications 7 à 9 ou selon la revendication 14 ou 15, **caractérisé en ce que** le moyen de production de pression (17) est conçu comme au moins un raccord vissé.

17. Dispositif semi-conducteur de puissance selon l'une des revendications précédentes, **caractérisé en ce que** le substrat (3) est conçu comme substrat DCB (Direct Copper Bonded) ou comme substrat métallique isolé.
